# EUROPEAN PATENT SPECIFICATION

(11) **EP 2 589 150 B1**
(45) Date of publication and mention of the grant of the patent: **30.12.2020**
(21) Application number: 11730843.7
(22) Date of filing: 30.06.2011
(51) Int. Cl.: H03K 19/0185

(54) **MULTI-VOLTAGE LEVEL, MULTI-DYNAMIC CIRCUIT STRUCTURE DEVICE**
VORRICHTUNG MIT MULTIDYNAMISCHEM SCHALTKREISAUFBAU MIT MEHREREN SPANNUNGSSTUFEN
DISPOSITIF À STRUCTURE À PLUSIEURS CIRCUITS DYNAMIQUES À PLUSIEURS NIVEAUX DE TENSION

(30) Priority: 01.07.2010 US 828719
(43) Date of publication of application: 08.05.2013
(73) Proprietor: Qualcomm Incorporated, San Diego, CA 92121 (US)
(72) Inventor: LIN, Jentsung Ken, San Diego, California 92121 (US)
(74) Representative: Dunlop, Hugh Christopher
(86) International application number: PCT/US2011/042486
(87) International publication number: WO 2012/003254

(56) References cited:
- WO-A1-2006/025025
- US-A- 6 049 231
- US-A1- 2003 141 899
- US-A1- 2006 001 442

## Description

### I. Field

The present disclosure is generally related to dynamic circuit structures.

### II. Description of Related Art

Advances in technology have resulted in smaller and more powerful personal computing devices. For example, there currently exist a variety of portable personal computing devices, including wireless computing devices, such as portable wireless telephones, personal digital assistants (PDAs), and paging devices that are small, lightweight, and easily carried by users. More specifically, portable wireless telephones, such as cellular telephones and Internet Protocol (IP) telephones, can communicate voice and data packets over wireless networks. Many such wireless telephones incorporate additional devices to provide enhanced functionality for end users. For example, a wireless telephone can also include a digital still camera, a digital video camera, a digital recorder, and an audio file player. Each of these portable personal computing devices may include a variety of different electronic devices all of which consume some amount of power.

Integrated circuits used in portable personal computing devices may employ multiple voltage domains. For example, circuitry in a "high" voltage domain can operate with higher supply voltage (Vdd H) than circuitry in a "low" voltage domain that operates using a lower supply voltage (Vdd L). To illustrate, logic circuitry may operate at a lower supply voltage than core memory circuitry.

Voltage level shifters operate to convert a signal from a voltage level corresponding to a logic level (i.e. a logic "high" or a logic "low" signal) in one voltage domain to a voltage level corresponding to the logic level in another voltage domain. Conventionally, a voltage level shifter is designed based on the specific values of the supply voltages of the voltage domains and/or a difference between the supply voltages. It would be advantageous to provide a voltage level shifter capable of operation across a range of voltage domains.

US 2006/0001442 A1 relates to a method including precharging a first dynamic node, precharging a second dynamic node, and maintaining a first logic state of a signal on the first dynamic node responsive to a second logic state of a signal on the second dynamic node. The method further includes maintaining the second logic state of the signal on the second dynamic node responsive to the first logic state of the signal on the first dynamic node.

US 2003/0141899 A1 relates to a system and method, for converting a voltage input from a low voltage source to a voltage output at a high voltage source using a domino logic circuit design. An embodiment provides a low to high voltage conversion system. The system includes: a pull-up transistor coupled to a high voltage source for charging a node, when a precharge signal is received; a low voltage source used for setting an input voltage; a pull-down network for discharging the node depending, at least in part, on the input voltage; and an output voltage determined from the node.

### III. Summary

A group of dynamic circuits operate as a voltage level shifter. The dynamic circuits are initialized and an input signal from a first voltage domain is provided to a selected one of the dynamic circuits in a second voltage domain. The input signal causes a dynamic node of the selected dynamic circuit to discharge, generating an output signal in the second voltage domain. In response to the discharge of the dynamic node of the selected dynamic circuit, keeper circuits at the other dynamic circuits are enabled to prevent discharging of dynamic nodes at the other dynamic circuits due to leakage current from NFET pull-down devices. The voltage level of the output signal is shifted compared to the voltage level of the input signal.

The present invention is defined by independent claim 1 directed to an apparatus for shifting voltage levels and corresponding independent method claim 6.

One particular advantage provided by at least one of the disclosed embodiments is that a keeper circuit of a dynamic circuit structure is not enabled during discharge of a dynamic node of the dynamic circuit structure. Thus, contention between the discharge circuit and the keeper circuit during discharge of the dynamic node is reduced, or in some cases, eliminated. As a result, power consumption of the dynamic circuit structure during discharge of the dynamic node decreases, the speed at which the dynamic node discharges increases, and the level shifter can operate at a lower Vdd L level.

### IV. Brief Description of the Drawings

FIG. 1 is a block diagram of a first illustrative embodiment of a system including dynamic circuit structures operating at multiple voltage levels;
FIG. 2 is a diagram of a second illustrative embodiment of a system including dynamic circuit structures operating at multiple voltage levels;
FIG. 3 is an illustration of a timing diagram corresponding to the system of FIG. 2;
FIG. 4 is a flow diagram of a particular illustrative embodiment of a method of operating a dynamic circuit structure at multiple voltage levels;
FIG. 5 is a block diagram of a first particular embodiment of a system that includes a multi-voltage domain, multi-dynamic circuit structure device; and
FIG. 6 is a block diagram of a second particular embodiment of a system that includes a multi-voltage domain, multi-dynamic circuit structure device.

### V. Detailed Description

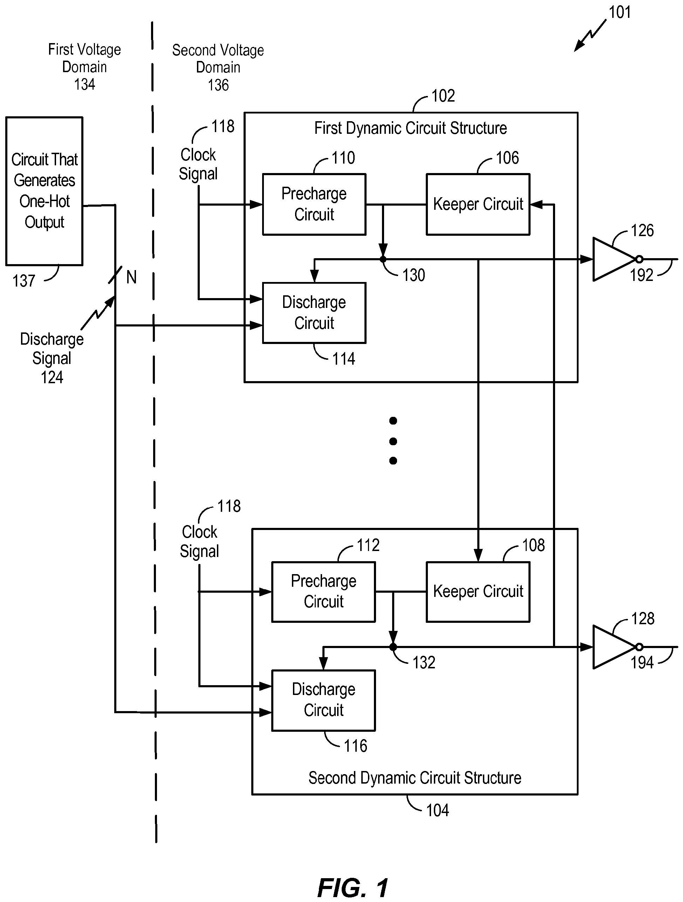

Referring to FIG. 1, a first embodiment of a system that includes multi-voltage level dynamic circuit structures is depicted. The system of FIG. 1 includes a circuit 137 that generates one-hot output in a first voltage domain 134 coupled to a plurality of dynamic circuit structures 101 in a second voltage domain 136 including a representative first dynamic circuit structure 102 and a representative second dynamic circuit structure 104. The first dynamic circuit structure 102 includes a first precharge circuit 110, a first discharge circuit 114, and a first keeper circuit 106 coupled at a first dynamic node 130. The second dynamic circuit structure 104 includes a second precharge circuit 112, a second discharge circuit 116, and a second keeper circuit 108 coupled at a second dynamic node 132. The first keeper circuit 106 is coupled to the second dynamic node 132 of the second dynamic circuit structure 104. The second keeper circuit 108 is coupled to the first dynamic node 130 of the first dynamic circuit structure 102. The plurality of dynamic circuit structures 101 operates as a level shifter that shifts a one-hot discharge signal 124 from the first voltage domain 134 to an output signal 192 or 194 corresponding to the second voltage domain 136.

The circuit 137 (which may be a one-hot decoder circuit) is configured to generate the discharge signal 124 as a one-hot signal. For example, the one-hot decoder circuit 137 may be coupled to a bus having N lines, and each line of the bus may be coupled to a separate discharge circuit 114, 116. The circuit 137 that generates one-hot output may assert a single line of the N-line bus and leave all remaining lines unasserted. The discharge signal 124 may therefore include multiple individual signals, only one of which is asserted at a time, that are provided to the plurality of dynamic circuit structures 101.

The first dynamic circuit structure 102 is configured to provide an output 192 via the first dynamic node 130 and an inverter 126. The output 192 is provided in response to a clock signal 118 from the second voltage domain 136 and the discharge signal 124 from the first voltage domain 134. Signals received from a voltage domain may be at a voltage level within a particular range of voltage levels. For example, the first voltage domain 134 may include a range of voltage levels from a ground reference voltage (0 Volts) to Vdd_L and the second voltage domain 136 may include a range of voltage levels from the ground reference voltage to Vdd_H, where Vdd_H is greater than Vdd_L.

The first precharge circuit 110 receives the clock signal 118 as an input and either couples or decouples the first dynamic node 130 to a voltage supply in response to the input. The first discharge circuit 114 is configured to discharge the first dynamic node 130 responsive to the clock signal 118 and the discharge signal 124. The first keeper circuit 106 is responsive to a voltage at the second dynamic node 132 as an input and either couples or decouples the first dynamic node 130 to the voltage supply in response to the input. For example, the first keeper circuit 106 couples the first dynamic node 130 to the voltage supply when the second dynamic node 132 is discharged. As used herein, a node is "discharged" when a voltage at the node transitions from a logic high voltage level to substantially zero volts, i.e. a ground value.

The second dynamic circuit structure 104 is configured to provide an output 194 via the second dynamic node 132 and an inverter 128 in response to the clock signal 118 and the discharge signal 124. The second prcchargc circuit 112 receives the clock signal 118 as an input and either couples or decouples the second dynamic node 132 to a voltage supply in response to the input. The second discharge circuit 116 is configured to discharge the second dynamic node 132 responsive to the clock signal 118 and the discharge signal 124. The second keeper circuit 108 is responsive to a voltage at the first dynamic node 130 as an input and either couples or decouples the second dynamic node 132 to the voltage supply in response to the input. For example, the second keeper circuit 108 couples the second dynamic node 132 to the voltage supply when the first dynamic node 130 is discharged.

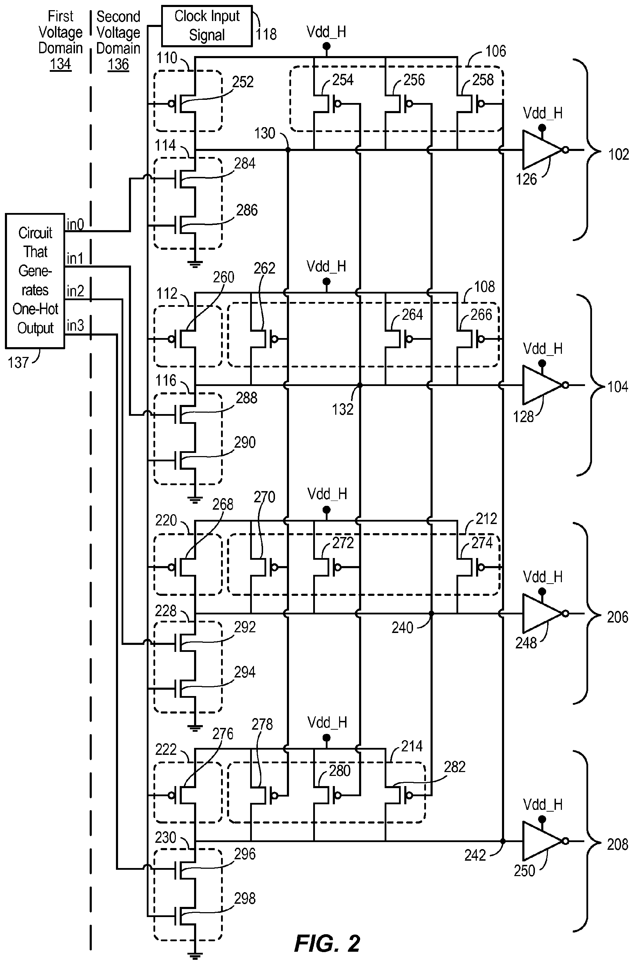

The keeper circuits 106, 108 can include one or more pull-up devices, such as a P-channel Field Effect Transistor (PFET) configured to selectively couple one of the dynamic nodes 130-132 to the supply Vdd H in response to a voltage at another of the dynamic nodes 130-132. For example, when the clock signal 118 has a logic high value, the dynamic nodes 130, 132 may gradually change state (from Vdd_H to ground) due to the leakage paths through N-channel FET (NFET) pull down devices. The keepers 106, 108 compensate for the leakage current and maintain the dynamic nodes 130, 132 at the Vdd H level. An illustrative example of the keeper circuits 106, 108 is shown in FIG. 2. In a particular embodiment, because the keeper circuits 106, 108 are controlled by a voltage within the second voltage domain 136 (i.e. not by a signal from the first voltage domain 134), the keeper circuits 106, 108 enable voltage level shifting with improved voltage operation range among Vdd_L and Vdd H domains. In addition, the process variation which affects keeper and NFET pull down transistor's driving strength (which depends on the PN ratio of keeper and NFET size) could be reduced or avoided. Further, the Vdd L domain operation range may be lowed due to a ratioless design and may have no dependence on the gap between Vdd_H and Vdd_L.

During operation, the first and second dynamic nodes 130, 132 are precharged during a precharge time period during which the precharge circuits 110, 112 are enabled by the clock signal 118 and the discharge circuits 114, 116 are disabled by the clock signal 118. In response to the dynamic nodes 130, 132 being precharged, the keeper circuits 106, 108 are disabled.

Following the precharge of the dynamic nodes 130 and 132, only one of the first discharge circuit 114 and the second discharge circuit 116 is enabled by the discharge signal 124. The discharge signal 124 may be a "one-hot" signal where only one of multiple signals is asserted, i.e. "hot," at a time (i.e., each of the multiple discharge signals are mutually exclusive with respect to all other discharge signals). As a result, only one of the first discharge circuit 114 and the second discharge circuit 116 may be enabled during a discharge time period following the precharge time period.

In response to a transition of the clock signal 118, the precharge circuits 110, 112 are disabled and the discharge circuit 114 or 116 that receives the asserted discharge signal 124 is enabled. For example, when the first discharge circuit 114 is enabled via the discharge signal 124, the second discharge circuit 116 is not enabled. As a result, the first discharge circuit 114 discharges the first dynamic node 130. The second discharge circuit 116 is not enabled and does not discharge the second dynamic node 132.

The first dynamic node 130, in response to receiving the one-hot discharge signal 124 from the first voltage domain 134 (e.g. an input at Vdd_L), discharges to ground, causing the inverter 126 to provide a high value at the output 192 corresponding to the second voltage domain 136 (e.g. an output at Vdd H). The second dynamic node 132, in response to receiving a low input from the first voltage domain 134 (e.g. at 0V), remains charged at a high voltage level in the second domain 136 (e.g. at Vdd H), causing the inverter 128 to provide a low value at the output 194 (e.g. at 0V). Thus, the plurality of dynamic circuit structures 101 operates to shift a voltage level of a one-hot input signal from the first voltage domain 134 to a one-hot output signal corresponding to the second voltage domain 136.

Because the second dynamic node 132 remains at a logic high voltage level, the first keeper circuit 106 remains disabled during the discharge of the first dynamic node 130. As a result, there is no contention between the first keeper circuit 106 and the first discharge circuit 114 when discharging the first dynamic node 130.

In response to the discharge of the first dynamic node 130, the second keeper circuit 108 maintains the voltage level of the dynamic node 132 at or nearly at the precharge voltage level. That is, the second keeper circuit 108 may maintain the second dynamic node 132 at a logic high voltage level of the second voltage domain 136.

Thus, the plurality of dynamic circuit structures 101 can operate as a voltage level shifter, receiving a logic high signal from the first voltage domain 134 (i.e. the asserted discharge signal 124) and outputting a logic high signal of the second voltage domain 136 (i.e. the output 192 or 194). The precharge circuits 110, 112 and the keeper circuits 106, 108 are disabled during discharge of the dynamic node 130 or 132 to reduce or eliminate contention. Reducing contention during discharge may reduce power consumption and may increase a speed of operation. The voltage level shifter may operate with lower power, increased speed, larger operating range, lower Vdd_L, and reduced sensitivity to process variation than level shifter designs that include contention and/or that enable a keeper using signals from Vdd_L. Although FIG. 1 illustrates two representative dynamic circuit structures 102 and 104, in other embodiments the plurality of dynamic circuit structures 101 may include more than two dynamic circuit structures, such as illustrated in FIG. 2.

Referring to FIG. 2, an illustrative example of an implementation of the system of FIG. 1 is depicted. The system of FIG. 2 includes the circuit 137 in the first voltage domain 134 coupled to the first dynamic circuit structure 102 and to the second dynamic circuit structure 104 in the second voltage domain 136. The circuit 137 is also coupled to a third dynamic circuit structure 206 and to a fourth dynamic circuit structure 208 in the second voltage domain 136. The circuit 137 is configured to provide an asserted discharge signal from the first voltage domain 134 to a single one of the dynamic circuit structures 102, 104, 206, and 208 via lines *in0, in1, in2,* and *in3,* respectively.

The first precharge circuit 110 of the first dynamic circuit structure 102 includes a precharge transistor 252 illustrated as a P-channel Field Effect Transistor (PFET). The precharge transistor 252 has a first terminal coupled to a voltage supply Vdd_H (i.e. the second voltage domain 136), a second terminal coupled to the first dynamic node 130, and a gate terminal coupled to receive the clock signal 118.

The first discharge circuit 114 includes a first discharge transistor 284 and a second discharge transistor 286 illustrated as N-channel FETs (NFETs). The first discharge transistor 284 has a first terminal coupled to the first dynamic node 130, a second terminal coupled to the second discharge transistor 286, and a gate terminal coupled to receive the *in0* signal from the circuit 137. The second discharge transistor 286 has a first terminal coupled to the first discharge transistor 284, a second terminal coupled to a reference voltage supply (i.e. a ground terminal), and a gate terminal coupled to receive the clock input signal 118.

The first keeper circuit 106 includes a first keeper transistor 254, a second keeper transistor 256, and a third keeper transistor 258, illustrated as PFETs. Each keeper transistor 254-258 has a first terminal coupled to Vdd_H and a second terminal coupled to the first dynamic node 130. The first keeper transistor 254 has a gate terminal coupled to the second dynamic node 132 of the second dynamic circuit structure 104. The second keeper transistor 256 has a gate terminal coupled to a third dynamic node 240 of the third dynamic circuit structure 206. The third keeper transistor 258 has a gate terminal coupled to a fourth dynamic node 242 of the fourth dynamic circuit structure 208.

The first keeper circuit 106 is enabled by a discharge of any of the dynamic nodes 132, 240, and 242 of the other dynamic circuit structures 104, 206, and 208, respectively. For example, when the second dynamic node 132 discharges, the first keeper transistor 254 couples the first dynamic node 130 to Vdd_H. When none of the dynamic nodes 132, 240, and 242 are discharged, the first keeper circuit 106 is disabled, decoupling the first dynamic node 130 from Vdd_H and enabling the first dynamic node 130 to discharge without contention from the first keeper circuit 106.

The dynamic circuit structures 104, 206, and 208 are similar to the first dynamic circuit structure 102. For example, the second precharge circuit 112 of the second dynamic circuit structure 104 includes a precharge transistor 260 responsive to the clock signal 118. The second discharge circuit 116 includes a first discharge transistor 288 responsive to the *in1* signal from the circuit 137 and a second discharge transistor 290 responsive to the clock signal 118. The second keeper circuit 108 includes keeper transistors 262, 264, and 266 coupled in parallel between Vdd_H and the second dynamic node 132. Each keeper transistor 262, 264, and 266 is responsive to a voltage at a dynamic node 130, 240, and 242 of another dynamic circuit structure 102, 206, and 208, respectively.

The third dynamic circuit structure 206 includes the third dynamic node 240 coupled to a third precharge circuit 220, a third discharge circuit 228, and a third keeper circuit 212. An inverter 248 is coupled to the third dynamic node 240 to provide an output. The third precharge circuit 220 includes a precharge transistor 268 responsive to the clock signal 118. The third discharge circuit 228 includes a first discharge transistor 292 responsive to the *in2* signal from the circuit 137 and a second discharge transistor 294 responsive to the clock signal 118. The third keeper circuit 212 includes keeper transistors 270, 272, and 274 coupled in parallel between Vdd_H and the third dynamic node 240. Each keeper transistor 270, 272, and 274 is responsive to a voltage at a dynamic node 130, 132, and 242 of another dynamic circuit structure 102, 104, and 208, respectively.

The fourth dynamic circuit structure 208 includes the fourth dynamic node 242 coupled to a fourth precharge circuit 222, a fourth discharge circuit 230, and a fourth keeper circuit 214. An inverter 250 is coupled to the fourth dynamic node 242 to provide an output. The fourth precharge circuit 222 includes a precharge transistor 276 responsive to the clock signal 118. The fourth discharge circuit 230 includes a first discharge transistor 296 responsive to the *in3* signal from the circuit 137 and a second discharge transistor 298 responsive to the clock signal 118. The fourth keeper circuit 214 includes keeper transistors 278, 280, and 282 coupled in parallel between Vdd_H and the fourth dynamic node 242. Each keeper transistor 278, 280, and 282 is responsive to a voltage at a dynamic node 130, 132, and 240 of another dynamic circuit structure 102, 104, and 206, respectively.

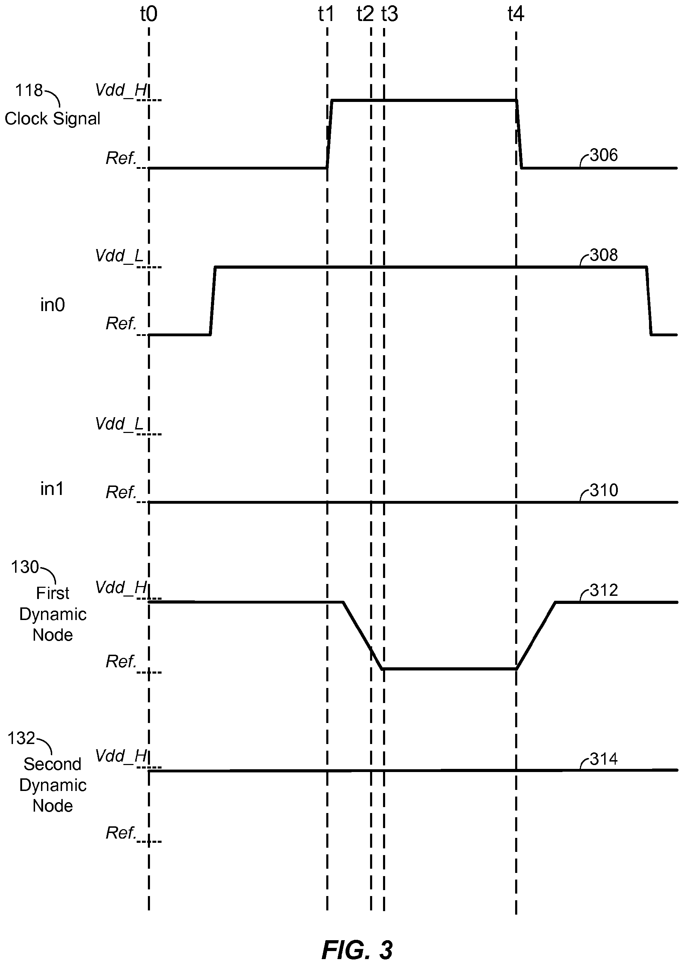

An example of an operation of the first and second dynamic circuit structures 102 and 104 is described with respect to FIG. 3. Although four dynamic circuit structures 102, 104, 206, and 208 are depicted in the example of FIG. 2 for explanatory purposes, readers of skill in the art will recognize that a system configured to operate as the system of FIG. 2 may include N dynamic circuit structures. The keeper circuit of each of the N dynamic circuit structures may be configured with N-1 keeper enable transistors, where each of the N-1 keeper enable transistors is tied to the dynamic node of the other dynamic circuit structures. In addition, although FIG. 2 illustrates an example of an implementation using a particular arrangement of PFETs and NFETs, other implementations may include the system of FIG. 2 modified by interchanging PFETs and NFETs and reversing the polarity of each voltage supply and signal (i.e. interchanging logic high voltages with logic low voltages).

Referring to FIG. 3, an illustration of a timing diagram corresponding to the system of FIG. 2 is depicted. The timing diagram of FIG. 3 includes traces 306, 308, 310, 312, and 314 illustrating voltage levels of the clock signal 118, the signals *in0* and *in1* of the circuit 137, the first dynamic node 130 and the second dynamic node 132, respectively, as functions of time.

A time *t0* represents a beginning of a precharge time period. At time *t0,* each of the traces 306-310 is illustrated at a ground reference voltage (i.e. a logic low voltage level) and traces 312 and 314 are at a logic high voltage level of the second voltage domain 136 (e.g. at Vdd_H). Between *t0* and *t1,* the clock signal 118 at the logic low voltage level disables the first discharge circuit 114 and causes the first precharge circuit 110 to couple the first dynamic node 130 to Vdd_H, holding the first dynamic node 130 at Vdd_H. The clock signal 118 at the logic low voltage level also disables the second discharge circuit 116 and causes the second precharge circuit 112 to couple the second dynamic node 132 to Vdd_H, holding the second dynamic node 132 at Vdd_H.

Also between *t0* and *t1,* the signal *in0* transitions from the ground reference voltage to Vdd_L, the logic high voltage level of the first voltage domain 134. Because *in0* and *in1* are provided by the one-hot decoder 137, only one of *in0* and *in1* may be at Vdd L at a time.

At time *t1* the clock signal 118 transitions from the ground reference voltage to Vdd_H, indicating the beginning of a discharge time period. In response to the clock signal 118 at the logic high level, the precharge circuits 110 and 112 are disabled. Responsive to the clock signal 118 and *in0* both at high logic voltage levels (although from different voltage domains), the first discharge circuit 114 discharges the first dynamic node 130. The second discharge circuit 116 responsive to the logic low voltage level of *in1* remains disabled because the logic low levels of the first voltage domain 134 and the second voltage domain 136 are substantially the same (e.g. 0V), preventing discharge of the second dynamic node 132 during the discharge time period.

Because *in0,* at a high logic level from the first voltage domain 134 (e.g. at Vdd_L), is used to turn on the first discharge transistor 284 and is not used to turn off a PFET, level shifting can be performed at a lower value of Vdd_L than in implementations where PFETs (e.g. keeper devices) are controlled by signals from the Vdd_L domain. In addition, because the keeper devices 254, 256 and 258 are off, NFETs 284 and 286 can discharge the first dynamic node 130 without contention from the keeper circuit 106.

In contrast to the system of FIG. 2, in conventional systems that have a node that discharges through an NFET in contention with a PFET keeper, low values of a voltage source applied to the NFET gate may cause a discharge current to be comparable to a keeper current, slowing a speed of operation and setting a lower limit on the voltage source. In such conventional systems, a ratio between the NFET and the PFET may be critical for operation and may cause the conventional voltage shifter to be susceptible to process variations.

As the first dynamic node 130 is discharging, at time *t2* the first dynamic node 130 transitions from a logic high voltage level to a logic low voltage level. Between *t1* and *t2* of the timing diagram, the first keeper circuit 106 is not enabled because the second dynamic node 132 remains at Vdd_H. In this way, there is no contention between the first keeper circuit 106 and the first discharge circuit 114 during discharge of the first dynamic node 130. In addition, the second keeper circuit 108 remains disabled between *t1* and *t2* while the first dynamic node 130 is discharging but is still above the logic low voltage level. Although the second dynamic node 132 remains precharged during the discharge time period, eventually a current leakage may cause a reduction in the voltage level at the second dynamic node 132. To ensure that the second dynamic node 132 remains at a logic high voltage level, the second keeper circuit 108 is enabled at *t2.* The first dynamic node 130 is substantially discharged at time t3.

The second keeper circuit 108 is controlled by the first dynamic node 130 from the second voltage domain 136. As a result, the second keeper circuit 108 operates substantially independent of a voltage level of the first voltage domain 134. Thus, level shifting operation is enabled at lower Vdd_L values than conventional level shifter circuits that have a stack keeper responsive to an input signal from a Vdd_L domain, which may be more susceptible to process variations and performance issues as a difference between Vdd_H and Vdd_L exceeds a threshold voltage of the stack keeper.

Between times *t3* and *t4* of the timing diagram, the traces 306-314 remain at a substantially steady state and the output of the circuits may be evaluated during an evaluation time period. At time t4, the clock signal 118 transitions to the ground reference voltage and a next precharge time period begins. In response to the transition of the clock signal 118 at time t4, the discharge circuits 114, 116 are disabled and the precharge circuits 110, 112 are enabled. The first keeper circuit 106 remains disabled, and the second keeper circuit 108 is disabled in response to the first dynamic node 130 precharging to the logic high voltage level. The discharge signal may be de-asserted from *in0* and may be asserted at another of the one-hot signals *in1-in3* in preparation for a next discharge period.

To illustrate principles of operation, the traces 306-314 may depict voltage levels and transitions between Vdd_H, Vdd_L, and the ground reference voltage under ideal or near-ideal conditions. In operation, one or more of the voltages depicted may deviate from the illustrated embodiment. For example, the first dynamic node 130 may not fully discharge to the ground reference voltage due to a non-zero voltage across the discharge transistors 284 and 286 of FIG. 2. Thus, the embodiment of FIG. 3 is presented for purposes of explanation and not of limitation.

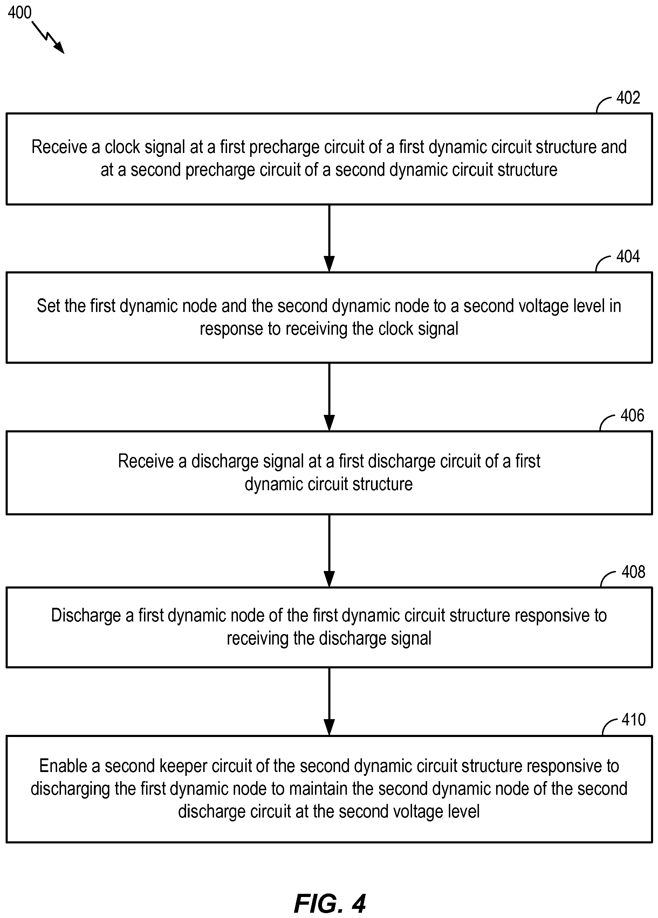

Referring to FIG. 4, a flow diagram of a first illustrative embodiment of a method of operating a dynamic circuit structure with reduced keeper circuit-discharge circuit contention is depicted. The dynamic circuit structure may operate to level shift a one-hot signal from a first voltage level (e.g. Vdd_L) to a second voltage level (e.g. Vdd_H).

A clock signal may be received at a first precharge circuit of a first dynamic circuit structure and at a second precharge circuit of a second dynamic circuit structure, at 402. For example, the clock signal may be the clock signal 118 of FIG. 1 that is received at the first precharge circuit 110 of the first dynamic circuit structure 102 and at the second precharge circuit 112 of the second dynamic circuit structure 104.

A first dynamic node of the first dynamic circuit structure and a second dynamic node of the second dynamic circuit structure may be set to the second voltage level in response to receiving the clock signal, at 404. For example, setting the first dynamic node to the second voltage level may include coupling a voltage source (e.g. a Vdd H source) to the first dynamic node via a first precharge transistor, such as the precharge transistor 252 of FIG. 2. Setting the second dynamic node to the second voltage level may include coupling the voltage source to the second dynamic node via a second precharge transistor, such as the precharge transistor 260 of FIG. 2.

A discharge signal is received at a first discharge circuit of the first dynamic circuit structure, at 406. The first dynamic node may be at the second voltage level and the first keeper circuit may be disabled when the discharge signal is received, such as described with respect to the trace 312 of FIG. 3 when the discharge signal is received between *t0* and *t1.* The discharge signal may be the discharge signal 124 of FIG. 1. The discharge signal may be received from a one-hot decoder circuit. In a particular embodiment, the discharge signal may be received from the circuit 137 of FIG. 1. The discharge signal is at a first voltage level that is different from the second voltage level.

The first dynamic node is discharged responsive to receiving the discharge signal, at 408. For example, the first discharge circuit may include a stacked pair of discharge transistors coupled to a reference voltage, such as the discharge transistors 284 and 286 of FIG. 2. Discharging the first dynamic node may include coupling the first dynamic node to the reference voltage, such as by applying a Vdd_L voltage from the circuit 137 to a gate of the first discharge transistor 284 and applying a Vdd_H voltage from the clock signal 118 to a gate of the second discharge transistor 286.

A second keeper circuit of the second dynamic circuit structure is enabled responsive to discharging the first dynamic node to maintain the second dynamic node of the second dynamic circuit structure at the first voltage level, at 410. For example, the second keeper circuit may maintain the second dynamic node at the second voltage level by coupling the second dynamic node to a voltage source. To illustrate, the second keeper circuit 108 of FIG. 2 may couple the second dynamic node 132 to Vdd_H in response to the keeper transistor 262 receiving a low logic level voltage from the discharged first dynamic node 130.

The first dynamic circuit structure and the second dynamic circuit structure may be included in a plurality of dynamic circuit structures. The plurality of dynamic circuit structures may include N dynamic circuit structures, and each dynamic circuit structure of the N dynamic circuit structures may include a keeper circuit having N-1 keeper transistors.

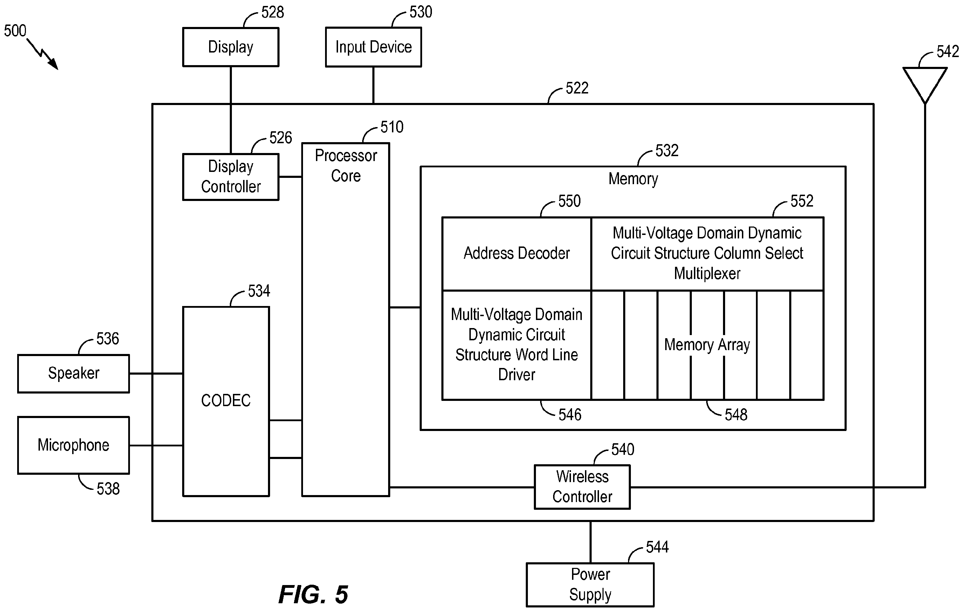

In a particular embodiment, receiving the discharge signal, discharging the first dynamic node, and enabling the second keeper circuit are performed at a processor integrated into an electronic device. Persons of skill in the art will also recognize that systems of FIGs. 1-2 may be implemented in a semiconductor die. Such a semiconductor die may be part of a processor, part of a memory circuit, or part of another circuit that is integrated into one or more electronic devices. The one or more electronic devices, for example, may be selected from a group of a set top box, a music player, a video player, an entertainment unit, a navigation device, a communications device, a personal digital assistant (PDA), a fixed location data unit, and a computer. As another illustrative, non-limiting example, the one or more electronic devices may be remote units such as mobile phones, hand-held personal communication systems (PCS) units, portable data units such as personal data assistants (PDA), global positioning system (GPS) enabled devices, navigation devices, fixed location data units such as meter reading equipment, any other device, or any combination thereof. Examples of such electronic devices are depicted in FIGs. 5-6.

FIG. 5 is a block diagram of a first particular embodiment of a system 500 that includes two multi-voltage domain dynamic circuit structure devices 546, 552. The system 500 may be implemented in a portable electronic device and includes a processor core 510, such as one or more general purpose processors or digital signal processors (DSPs), coupled to a computer readable medium, such as a memory 532, storing computer readable instructions and data. The memory 532 includes a memory array 548, an address decoder 550 and two dynamic driver circuits: a column select multiplexer circuit 552 and a wordline driver circuit 546. Each of the column select multiplexer circuit 552 and the wordline driver circuit 546 includes a multi-domain dynamic circuit structure device similar to the system depicted in FIG. 1 or the system depicted in FIG. 2. For example, each of the column select multiplexer circuit 552 and the wordline driver circuit 546 may function as a level shifter to perform a level shifting of a one-hot signal between a logic domain and a core memory domain.

The system 500 also includes a display controller 526 coupled to the processor core 510 and to a display device 528. A coder/decoder (CODEC) 534 can also be coupled to the processor core 510. A speaker 536 and a microphone 538 can be coupled to the CODEC 534. A wireless controller 540 can be coupled to the processor core 510 and to a wireless antenna 542.

In a particular embodiment, the processor core 510, the display controller 526, the memory 532, the CODEC 534, and the wireless controller 540 are included in a system-in-package or system-on-chip device 522. In a particular embodiment, an input device 530 and a power supply 544 are coupled to the system-on-chip device 522. Moreover, in a particular embodiment, as illustrated in FIG. 5, the display device 528, the input device 530, the speaker 536, the microphone 538, the wireless antenna 542, and the power supply 544 are external to the system-on-chip device 522. However, each of the display device 528, the input device 530, the speaker 536, the microphone 538, the wireless antenna 542, and the power supply 544 can be coupled to a component of the system-on-chip device 522, such as an interface or a controller.

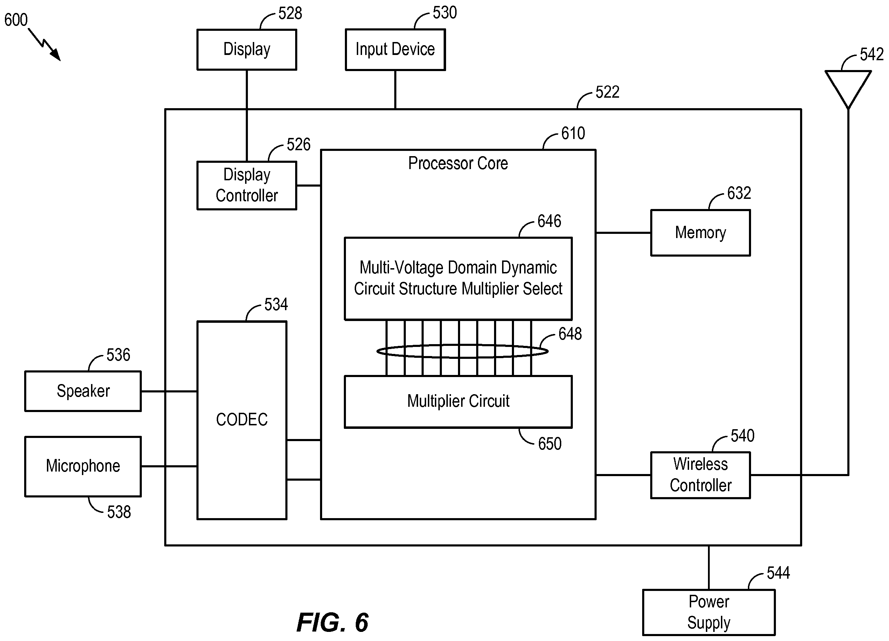

FIG. 6 is a block diagram of a particular embodiment of a system 600 that includes a multi-voltage domain dynamic circuit structure device 646. The system 600 may be implemented in a portable electronic device and includes the system-on-chip device 522 of FIG. 5 including the display controller 526, the CODEC 534, and the wireless controller 540, and also including a memory 632 coupled to a processor core 610. The input device 530, the display 528, the speaker 536, the microphone 538, and the power supply 544 may be coupled to the system-on-chip device 522.

The processor core 610 includes a multiplier select circuit 646 and a multiplier circuit 650. Coupling the multiplier select circuit 646 and the multiplier circuit 650 are a number of multiplier select lines 648. The multiplier select circuit 646 is configured with a multi-domain dynamic circuit structure device similar to the system depicted in FIG. 1 or the system depicted in FIG. 2.

Those of skill would further appreciate that the various illustrative logical blocks, configurations, modules, circuits, and method steps described in connection with the embodiments disclosed herein may be implemented as electronic hardware, computer software executed by a processing unit, or combinations of both. Various illustrative components, blocks, configurations, modules, circuits, and steps have been described above generally in terms of their functionality. Whether such functionality is implemented as hardware or executable processing instructions depends upon the particular application and design constraints imposed on the overall system. Skilled artisans may implement the described functionality in varying ways for each particular application, but such implementation decisions should not be interpreted as causing a departure from the scope of the present disclosure.

The steps of a method or algorithm described in connection with the embodiments disclosed herein may be embodied directly in hardware, in a software module executed by a processor, or in a combination of the two. A software module may reside in random access memory (RAM), a magnetoresistive random access memory (MRAM), a spin-torque-transfer magnetoresistive random access memory (STT-MRAM), flash memory, read-only memory (ROM), programmable read-only memory (PROM), erasable programmable read-only memory (EPROM), electrically erasable programmable read-only memory (EEPROM), registers, a hard disk, a removable disk, a compact disc read-only memory (CD-ROM), or any other form of storage medium known in the art. An exemplary storage medium is coupled to the processor such that the processor can read information from, and write information to, the storage medium. In the alternative, the storage medium may be integral to the processor. The processor and the storage medium may reside in an application-specific integrated circuit (ASIC). The ASIC may reside in a computing device or a user terminal. In the alternative, the processor and the storage medium may reside as discrete components in a computing device or user terminal.

The previous description of the disclosed embodiments is provided to enable a person skilled in the art to make or use the disclosed embodiments. Various modifications to these embodiments will be readily apparent to those skilled in the art, and the principles defined herein may be applied to other embodiments without departing from the scope of the disclosure. Thus, the present disclosure is not intended to be limited to the embodiments shown herein but is to be accorded the widest scope possible consistent with the principles and novel features as defined by the following claims.

## Claims

1. An apparatus for shifting voltage levels comprising:
a first dynamic circuit structure (102) comprising a first keeper circuit (106), a first discharge circuit (114), and a first precharge circuit (110), wherein the first keeper circuit (106), the first discharge circuit (114), and the first precharge circuit (110) are coupled to a first dynamic node (130) and wherein the first precharge circuit (110) is configured to precharge the first dynamic node (130) to a logic high voltage level of a second voltage domain, said first precharge circuit (110) and said first discharge circuit (114) further configured to receive a clock signal (118), wherein the first keeper circuit (106) is further coupled to a second dynamic node (132) of a second dynamic circuit structure (104); and
the second dynamic circuit structure (104) comprising a second keeper circuit (108), a second discharge circuit (116), and a second precharge circuit (112), wherein the second keeper circuit (108), the second discharge circuit (116), and the second precharge circuit (112) are coupled to the second dynamic node (132) and wherein the second precharge circuit (112) is configured to precharge the second dynamic node (132) to the logic high voltage level in the second domain, said second precharge circuit (112) and said second discharge circuit (116) further configured to receive the clock signal (118), wherein the second keeper circuit (108) is further coupled to the first dynamic node (130),
wherein the first discharge circuit (114) of the first dynamic circuit structure (102) and the second discharge circuit (116) of the second dynamic circuit structure (104) are further coupled to a discharge signal bus, said discharge signal bus configured to provide a discharge enabling signal (124) during a discharge time period to a single one of the first discharge circuit (114) and the second discharge circuit (116), the discharge enabling signal (124) being at a discharge voltage level different than the logic high voltage level in the second domain;
wherein, the first precharge circuit (110) is configured to precharge the first dynamic node (130) to the logic high voltage level based on the clock signal and wherein the first discharge circuit (114) is configured to selectively discharge the first dynamic node (130) based on the clock signal (118) and the discharge enabling signal (124) during the discharge time period as a first output signal (192);
wherein, the second precharge circuit (112) is configured to precharge the second dynamic node (132) to the logic high voltage level based on the clock signal and wherein the second discharge circuit (116) is configured to selectively discharge the second dynamic node (132) based on the clock signal (118) and the discharge enabling signal (124) during the discharge time period as a second output signal (194), wherein only one of the first dynamic node and the second dynamic node are configured to discharge during the discharge time period;
wherein the first keeper circuit (106) is configured to be enabled in response to determining that the second dynamic node (132) is discharged, and further configured to maintain the voltage level of the first dynamic node (130) substantially at the logic high voltage level in response to the determination; and
wherein the second keeper circuit (108) is configured to be enabled in response to determining that the first dynamic node (130) is discharged, and further configured to maintain the voltage level of the second dynamic node (132) substantially at the logic high voltage level in response to the determination.

2. The apparatus of claim 1 integrated in at least one semiconductor die.

3. The apparatus of claim 1, further comprising a device selected from the group consisting of a set top box, a music player, a video player, an entertainment unit, a navigation device, a communications device, a personal digital assistant, PDA, a fixed location data unit, and a computer, into which the first dynamic circuit structure and the second dynamic circuit structure are integrated.

4. The apparatus of claim 1, wherein the discharge circuit of each particular dynamic circuit structure of the plurality of dynamic circuit structures is responsive to a corresponding discharge signal (124) outputed from a one-hot decoder circuit (137).

5. The apparatus of claim 1, further comprising a memory device that includes a memory array and a dynamic driver circuit coupled to the memory array to drive a plurality of columns or word lines of the memory array, wherein the dynamic driver circuit comprises the plurality of dynamic circuit structures.

6. A method for shifting voltage levels, the method comprising:
receiving (402) a clock signal (118) at a first precharge circuit (110) of a first dynamic circuit structure (102) and at a second precharge circuit (112) of a second dynamic circuit structure (104);
setting (404) a first dynamic node (130) of the first dynamic circuit structure (102) and a second dynamic node (132) of the second dynamic circuit structure (104) to a logic high voltage level in response to receiving the clock signal (118), wherein setting the first dynamic node and the second dynamic node to the logic high voltage level comprises coupling a voltage source to the first dynamic node via the first precharge circuit and coupling the voltage source to the second dynamic node via the second precharge circuit;
receiving (406) a discharge enabling signal (124) at either a first discharge circuit (114) of the first dynamic circuit structure (102) or a second discharge circuit of the second dynamic circuit structure, wherein the first dynamic circuit structure further comprises a first keeper circuit (106) and the second dynamic circuit structure further comprises a second keeper circuit (108), wherein the discharge enabling signal is at a voltage level different to the first dynamic node and the second dynamic node, and when the discharge enabling signal is received at the first discharge circuit: the first keeper circuit is disabled when the discharge enabling signal is received;
the first dynamic node is discharged responsive to receiving the discharge enabling signal; and
the second keeper circuit (108) of the second dynamic circuit structure (104) is enabled in response to discharging the first dynamic node to maintain the second dynamic node (132) of the second dynamic circuit structure at substantially the logic high voltage level; and when the discharge enabling signal is received at the second discharge circuit:
the second keeper circuit is disabled when the discharge enabling signal is received;
the second dynamic node is discharged in response to receiving the discharge enabling signal; and
the first keeper circuit (106) of the first dynamic circuit structure is enabled in response to discharging the second dynamic node to maintain the first dynamic node of the first dynamic circuit structure at substantially the logic high voltage level.

7. The method of claim 6, wherein the first discharge circuit comprises a stacked pair of discharge transistors coupled to a reference voltage and wherein discharging the first dynamic node comprises coupling the first dynamic node to the reference voltage.

## Patentansprüche

1. Eine Vorrichtung zum Verschieben von Spannungspegeln, die Folgendes aufweist:
eine erste dynamische Schaltungsstruktur (102), die eine erste Keeper-bzw. Halteschaltung (106), eine erste Entladungsschaltung (114) und eine erste Vorladungsschaltung (110) aufweist, wobei die erste Halteschaltung (106), die erste Entladungsschaltung (114) und die erste Vorladungsschaltung (110) an einen ersten dynamischen Knoten (130) gekoppelt sind, und wobei die erste Vorladungsschaltung (110) konfiguriert ist zum Vorladen des ersten dynamischen Knotens (130) auf einen Logisch-Hoch-Spannungspegel eines zweiten Spannungsbereichs, wobei die erste Vorladungsschaltung (110) und die erste Entladungsschaltung (114) weiter konfiguriert sind zum Empfangen eines Taktsignals (118), wobei die erste Halteschaltung (106) weiter an einen zweiten dynamischen Knoten (132) einer zweiten dynamischen Schaltungsstruktur (104) gekoppelt ist; und
die zweite dynamische Schaltungsstruktur (104) eine zweite Halteschaltung (108), eine zweite Entladungsschaltung (116) und eine zweite Vorladungsschaltung (112) aufweist, wobei die zweite Halteschaltung (108), die zweite Entladungsschaltung (116) und die zweite Vorladungsschaltung (112) an den zweiten dynamischen Knoten (132) gekoppelt sind, und wobei die zweite Vorladungsschaltung (112) konfiguriert ist zum Vorladen des zweiten dynamischen Knotens (132) auf den Logisch-Hoch-Spannungspegel in dem zweiten Bereich, wobei die zweite Vorladungsschaltung (112) und die zweite Entladungsschaltung (116) weiter konfiguriert sind zum Empfangen des Taktsignals (118), wobei die zweite Halteschaltung (108) weiter an den ersten dynamischen Knoten (130) gekoppelt ist,
wobei die erste Entladungsschaltung (114) der ersten dynamischen Schaltungsstruktur (102) und die zweite Entladungsschaltung (116) der zweiten dynamischen Schaltungsstruktur (104) weiter an einen Entladungssignalbus gekoppelt sind, wobei der Entladungssignalbus konfiguriert ist zum Vorsehen eines Entladungsaktivierungssignals (124) während einer Entladungszeitperiode an eine einzelne von der ersten Entladungsschaltung (114) und der zweiten Entladungsschaltung (116), wobei das Entladungsaktivierungssignal (124) auf einem Entladungsspannungspegel ist, der sich von dem Logisch-Hoch-Spannungspegel in dem zweiten Bereich unterscheidet;
wobei die erste Vorladungsschaltung (110) konfiguriert ist zum Vorladen des ersten dynamischen Knotens (130) auf den Logisch-Hoch-Spannungspegel basierend auf dem Taktsignal, und wobei die erste Entladungsschaltung (114) konfiguriert ist zum selektiven Entladen des ersten dynamischen Knotens (130) basierend auf dem Taktsignal (118) und dem Entladungsaktivierungssignal (124) während der Entladezeitperiode als ein erstes Ausgangssignal (192);
wobei die zweite Vorladungsschaltung (112) konfiguriert ist zum Vorladen des zweiten dynamischen Knotens (132) auf den Logisch-Hoch-Spannungspegel basierend auf dem Taktsignal, und wobei die zweite Entladungsschaltung (116) konfiguriert ist zum selektiven Entladen des zweiten dynamischen Knotens (132) basierend auf dem Taktsignal (118) und dem Entladungsaktivierungssignal (124) während der Entladungszeitperiode als ein zweites Ausgangssignal (194), wobei nur einer von dem ersten dynamischen Knoten oder zweiten dynamischen Knoten konfiguriert ist zum Entladen während der Entladezeitperiode;
wobei die erste Halteschaltung (106) konfiguriert ist aktiviert zu werden ansprechend auf Bestimmen, dass der zweite dynamische Knoten (132) entladen ist, und weiter konfiguriert ist zum Beibehalten des Spannungspegels des ersten dynamischen Knotens (130) auf im Wesentlichen dem Logisch-Hoch-Spannungspegel ansprechend auf die Bestimmung; und
wobei die zweite Halteschaltung (108) konfiguriert ist aktiviert zu werden ansprechend auf Bestimmen, dass der erste dynamische Knoten (130) entladen ist, und weiter konfiguriert ist zum Beibehalten des Spannungspegels des zweiten dynamischen Knotens (132) auf im Wesentlichen dem Logisch-Hoch-Spannungspegel ansprechend auf die Bestimmung.

2. Vorrichtung nach Anspruch 1, die in wenigstens einen Halbleiter-Die integriert ist.

3. Vorrichtung nach Anspruch 1, die weiter eine Einrichtung aufweist, die aus der Gruppe ausgewählt ist, die aus Folgendem besteht: einer Set-Top-Box, einer Musikabspielvorrichtung, einer Videoabspielvorrichtung, einer Unterhaltungseinheit, einer Navigationseinrichtung, einer Kommunikationseinrichtung, einem persönlichen digitalen Assistenten bzw. PDA (PDA = personal digital assistant), einer Dateneinheiten mit festem Standort und einem Computer, in die bzw. den die erste dynamische Schaltungsstruktur und die zweite dynamische Schaltungsstruktur integriert sind.

4. Vorrichtung nach Anspruch 1, wobei die Entladungsschaltung jeder bestimmten dynamischen Schaltungsstruktur der Vielzahl von dynamischen Schaltungsstrukturen auf ein entsprechendes Entladungssignal (124) anspricht, dass von einer One-Hot-Decodiererschaltung (137) ausgegeben wird.

5. Vorrichtung nach Anspruch 1, die weiter eine Speichereinrichtung aufweist, die eine Speicheranordnung und eine dynamische Treiberschaltung aufweist, die an die Speicheranordnung zum Treiben bzw. Speisen einer Vielzahl von Spalten oder Wortleitungen der Speicheranordnung gekoppelt ist, wobei die dynamische Treiberschaltung die Vielzahl von dynamischen Schaltungsstrukturen aufweist.

6. Ein Verfahren zum Verschieben von Spannungspegeln, wobei das Verfahren Folgendes aufweist:
Empfangen (402) eines Taktsignals (118) an einer ersten Vorladungsschaltung (110) einer ersten dynamischen Schaltungsstruktur (102) und an einer zweiten Vorladungsschaltung (112) einer zweiten dynamischen Schaltungsstruktur (104);
Setzen (404) eines ersten dynamischen Knotens (130) der ersten dynamischen Schaltungsstruktur (102) und eines zweiten dynamischen Knotens (132) der zweiten dynamischen Schaltungsstruktur (104) auf einen Logisch-Hoch-Spannungspegel ansprechend auf Empfangen des Taktsignals (118), wobei das Setzen des ersten dynamischen Knotens und des zweiten dynamischen Knotens auf den Logisch-Hoch-Spannungspegel Koppeln einer Spannungsquelle an den ersten dynamischen Knoten über die erste Vorladungsschaltung und Koppeln der Spannungsquelle an den zweiten dynamischen Knoten über die zweite Vorladungsschaltung aufweist;
Empfangen (406) eines Entladungsaktivierungssignals (124) an entweder einer ersten Entladungsschaltung (114) der ersten dynamischen Schaltungsstruktur (102) oder einer zweiten Entladungsschaltung der zweiten dynamischen Schaltungsstruktur, wobei die erste dynamische Schaltungsstruktur weiter eine erste Keeper- bzw. Halteschaltung (106) aufweist und die zweite dynamische Schaltungsstruktur weiter eine zweite Halteschaltung (108) aufweist, wobei das Entladungsaktivierungssignal auf einem Spannungspegel ist, der sich von dem ersten dynamischen Knoten und dem zweiten dynamischen Knoten unterscheidet, und wobei, wenn das Entladungsaktivierungssignal an der ersten Entladungsschaltung empfangen wird: die erste Halteschaltung deaktiviert wird, wenn das Entladungsaktivierungssignal empfangen wird;
wobei der erste dynamische Knoten ansprechend auf Empfangen des Entladungsaktivierungssignals entladen wird; und
die zweite Halteschaltung (108) der zweiten dynamischen Schaltungsstruktur (104) aktiviert wird ansprechend auf Entladen des ersten dynamischen Knotens, um den zweiten dynamischen Knoten (132) der zweiten dynamischen Schaltungsstruktur auf im Wesentlichen dem Logisch-Hoch-Spannungspegel zu halten; und wenn das Entladungsaktivierungssignal an der zweiten Entladungsschaltung empfangen wird:
die zweite Halteschaltung deaktiviert wird, wenn das Entladungsaktivierungssignal empfangen wird;
wobei der zweite dynamische Knoten ansprechend auf Empfangen des Entladungsaktivierungssignals entladen wird; und
die erste Halteschaltung (106) der ersten dynamischen Schaltungsstruktur ansprechend auf Entladen des zweiten dynamischen Knotens aktiviert wird, um den ersten dynamischen Knoten der ersten dynamischen Schaltungsstruktur auf im Wesentlichen dem Logisch-Hoch-Spannungspegel zu halten.

7. Verfahren nach Anspruch 6, wobei die erste Entladungsschaltung ein gestapeltes bzw. gestacktes Paar von Entladungstransistoren aufweist, die an eine Referenzspannung gekoppelt sind, und wobei das Entladen des ersten dynamischen Knotens Koppeln des ersten dynamischen Knotens an die Referenzspannung aufweist.

## Revendications

1. Appareil de décalage de niveaux de tension comprenant :
une première structure de circuits dynamiques (102) comprenant un premier circuit de maintien (106), un premier circuit de décharge (114), et un premier circuit de précharge (110), dans laquelle le premier circuit de maintien (106), le premier circuit de décharge (114), et le premier circuit de précharge (110) sont couplés à un premier nœud dynamique (130) et dans laquelle le premier circuit de précharge (110) est configuré pour précharger le premier nœud dynamique (130) à un niveau de tension logique haut d'un second domaine de tension, ledit premier circuit de précharge (110) et ledit premier circuit de décharge (114) étant configurés en outre pour recevoir un signal d'horloge (118), dans laquelle le premier circuit de maintien (106) est couplé en outre à un second nœud dynamique (132) d'une seconde structure de circuits dynamiques (104) ; et
la seconde structure de circuits dynamiques (104) comprenant un second circuit de maintien (108), un second circuit de décharge (116), et un second circuit de précharge (112), dans laquelle le second circuit de maintien (108), le second circuit de décharge (116), et le second circuit de précharge (112) sont couplés au second nœud dynamique (132) et dans laquelle le second circuit de précharge (112) est configuré pour précharger le second nœud dynamique (132) au niveau de tension logique haut dans le second domaine, ledit second circuit de précharge (112) et ledit second circuit de décharge (116) étant configurés en outre pour recevoir le signal d'horloge (118), dans laquelle le second circuit de maintien (108) est couplé en outre au premier nœud dynamique (130),
dans lequel le premier circuit de décharge (114) de la première structure de circuits dynamiques (102) et le second circuit de décharge (116) de la seconde structure de circuits dynamiques (104) sont couplés en outre à un bus de signal de décharge, ledit bus de signal de décharge étant configuré pour fournir un signal d'activation de décharge (124) durant une période de décharge à un seul du premier circuit de décharge (114) et du second circuit de décharge (116), le signal d'activation de décharge (124) étant à un niveau de tension de décharge différent du niveau de tension logique haut dans le second domaine ;
dans lequel, le premier circuit de précharge (110) est configuré pour précharger le premier nœud dynamique (130) au niveau de tension logique haut sur la base du signal d'horloge et le premier circuit de décharge (114) est configuré pour décharger sélectivement le premier nœud dynamique (130) sur la base du signal d'horloge (118) et du signal d'activation de décharge (124) durant la période de décharge comme premier signal de sortie (192),
dans lequel, le second circuit de précharge (112) est configuré pour précharger le second nœud dynamique (132) au niveau de tension logique haut sur la base du signal d'horloge et le second circuit de décharge (116) est configuré pour décharger sélectivement le second nœud dynamique (132) sur la base du signal d'horloge (118) et du signal d'activation de décharge (124) durant la période de décharge comme second signal de sortie (194), un seul du premier nœud dynamique et du second nœud dynamique étant configuré pour se décharger durant la période de décharge ;
dans lequel le premier circuit de maintien (106) est configuré pour être activé en réponse à la détermination que le second nœud dynamique (132) est déchargé, et configuré en outre pour maintenir le niveau de tension du premier nœud dynamique (130) sensiblement au niveau de tension logique haut en réponse à la détermination ; et
dans lequel le second circuit de maintien (108) est configuré pour être activé en réponse à la détermination que le premier nœud dynamique (130) est déchargé, et configuré en outre pour maintenir le niveau de tension du second nœud dynamique (132) sensiblement au niveau de tension logique haut en réponse à la détermination.

2. Appareil selon la revendication 1 intégré dans au moins un dé de semi-conducteur.

3. Appareil selon la revendication 1, comprenant en outre un dispositif sélectionné dans le groupe consistant en un décodeur, un lecteur de musique, un lecteur vidéo, une unité de divertissement, un dispositif de navigation, un dispositif de communication, un assistant numérique personnel, PDA, une unité de données à emplacement fixe et un ordinateur, dans lequel la première structure de circuits dynamiques et la seconde structure de circuits dynamiques sont intégrées.

4. Appareil selon la revendication 1, dans laquelle le circuit de décharge de chaque structure de circuits dynamiques particulière de la pluralité de structures de circuits dynamiques répond à un signal de décharge correspondant (124) délivré par un circuit décodeur 1 parmi n (137).

5. Appareil selon la revendication 1, comprenant en outre un dispositif de mémoire qui comporte une matrice de mémoire et un circuit d'attaque dynamique couplé à la matrice de mémoire pour attaquer une pluralité de colonnes ou de lignes de mots de la matrice de mémoire, le circuit d'attaque dynamique comprenant la pluralité de structures de circuits dynamiques.

6. Procédé de décalage de niveaux de tension, le procédé comprenant :
la réception (402) d'un signal d'horloge (118) au niveau d'un premier circuit de précharge (110) d'une première structure de circuits dynamiques (102) et au niveau d'un second circuit de précharge (112) d'une seconde structure de circuits dynamiques (104) ;
le réglage (404) d'un premier nœud dynamique (130) de la première structure de circuits dynamiques (102) et d'un second nœud dynamique (132) de la seconde structure de circuits dynamiques (104) à un niveau de tension logique haut en réponse à la réception du signal d'horloge (118), le réglage du premier nœud dynamique et du second nœud dynamique au niveau de tension logique haut comprenant le couplage d'une source de tension au premier nœud dynamique par l'intermédiaire du premier circuit de précharge et le couplage de la source de tension au second nœud dynamique par l'intermédiaire du second circuit de précharge ;
la réception (406) d'un signal d'activation de décharge (124) au niveau d'un premier circuit de décharge (114) de la première structure de circuits dynamiques (102) ou d'un second circuit de décharge de la seconde structure de circuits dynamiques, dans lequel la première structure de circuits dynamiques comprend en outre un premier circuit de maintien (106) et la seconde structure de circuits dynamiques comprend en outre un second circuit de maintien (108), dans lequel le signal d'activation de décharge est à un niveau de tension différent du premier nœud dynamique et du second nœud dynamique, et quand le signal d'activation de décharge est reçu au niveau du premier circuit de décharge : le premier circuit de maintien est désactivé quand le signal d'activation de décharge est reçu ;
le premier nœud dynamique est déchargé en réponse à la réception du signal d'activation de décharge ; et
le second circuit de maintien (108) de la seconde structure de circuits dynamiques (104) est activé en réponse à la décharge du premier nœud dynamique pour maintenir le second nœud dynamique (132) de la seconde structure de circuits dynamiques sensiblement au niveau de tension logique haut ; et quand le signal d'activation de décharge est reçu au niveau du second circuit de décharge :
le second circuit de maintien est désactivé quand le signal d'activation de décharge est reçu;
le second nœud dynamique est déchargé en réponse à la réception du signal d'activation de décharge ; et
le premier circuit de maintien (106) de la première structure de circuits dynamiques est activé en réponse à la décharge du second nœud dynamique pour maintenir le premier nœud dynamique de la première structure de circuits dynamiques sensiblement au niveau de tension logique haut.

7. Procédé selon la revendication 6, dans lequel le premier circuit de décharge comprend une paire empilée de transistors de décharge couplée à une tension de référence et dans lequel la décharge du premier nœud dynamique comprend le couplage du premier nœud dynamique à la tension de référence.
